(19) Europäisches Patentamt
European Patent Office
Office européen des brevets

(11) EP 1 350 815 A1

(12) **EUROPEAN PATENT APPLICATION**
published in accordance with Art. 158(3) EPC

(43) Date of publication:
**08.10.2003 Bulletin 2003/41**

(21) Application number: **01999262.7**

(22) Date of filing: **10.12.2001**

(51) Int Cl.7: **C08L 101/00**, C08K 3/34, C08J 5/00, B32B 27/20, H01L 23/14, H01B 3/00, H05K 1/03, H05K 3/46

(86) International application number:
**PCT/JP01/10771**

(87) International publication number:
**WO 02/046312 (13.06.2002 Gazette 2002/24)**

(84) Designated Contracting States:
**AT BE CH CY DE DK ES FI FR GB GR IE IT LI LU MC NL PT SE TR**

(30) Priority: **08.12.2000 JP 2000374799**
**29.03.2001 JP 2001096652**
**11.05.2001 JP 2001141887**
**11.05.2001 JP 2001141888**

(71) Applicant: **SEKISUI CHEMICAL CO., LTD.**
**Osaka-shi, Osaka 530-8565 (JP)**

(72) Inventors:
- **YONEZAWA, Koji, Sekisui Chemical Co., Ltd. Mishima-gun, Osaka 618-8589 (JP)**
- **SHIBAYAMA, Koichi, Sekisui Chemical Co., Ltd. Mishima-gun, Osaka 618-8589 (JP)**
- **FUSHIMI, Masao, Sekisui Chemical Co., Ltd. Mishima-gun, Osaka 618-8589 (JP)**
- **TAKAHASHI, Hideyuki, Sekisui Chemical Co., Ltd. Mishima-gun, Osaka 618-8589 (JP)**
- **TANIGUCHI, Koji, Sekisui Chemical Co., Ltd. Mishima-gun, Osaka 618-8589 (JP)**
- **YAGI, Motohiro, Sekisui Chemical Co., Ltd. Mishima-gun, Osaka 618-8589 (JP)**

(74) Representative: **Hubert, Philippe et al**
**Cabinet Beau de Loménie**
**158, rue de l'Université**
**75340 Paris Cédex 07 (FR)**

(54) **MATERIAL FOR INSULATING SUBSTRATE, PRINTED BOARD, LAMINATE, COPPER FOIL WITH RESIN, COPPER-CLAD LAMINATE, POLYIMIDE FILM, FILM FOR TAB, AND PREPREG**

(57) It is an object of the invention to provide a material for insulating substrate, a printed board, a laminate, copper foil with resin, a copper-clad laminate, a polyimide film, a film for TAB and a prepreg, which are excellent in physical properties, dimensional stability, heat resistance, flame retardancy etc. and exhibit an excellent flame retardant effect particularly by a shape retention effect at the time of combustion

The invention provides a material for insulating substrate, comprising 100 parts by weight of a thermoplastic resin or a mixture of a thermoplastic resin and a thermosetting resin and 0.1 to 100 parts by weight of a layered silicate.

EP 1 350 815 A1

## Description

### TECHNICAL FIELD

The present invention relates to a material for insulating substrate, a printed board, a laminate, copper foil with resin, a copper-clad laminate, a polyimide film, a film for TAB and a prepreg, which are excellent in physical properties, dimensional stability, heat resistance, flame retardancy etc. and exhibit an excellent flame retardant effect particularly by a shape retention effect at the time of combustion.

### BACKGROUND ART

Generally, a multi-layer print substrate used in electronic devices is constituted from a multi-layer insulating substrate, and this interlaminar insulating substrate makes use of a thermosetting resin prepreg having a glass cloth impregnated with a thermosetting resin, or a film consisting of a thermosetting resin or a photosetting resin.

As the multi-layer print substrate is made highly denser and thinner in recent years, there is demand for a very thin interlaminar substrate, and an interlaminar insulating substrate using a thin glass cloth or not using a glass cloth is required. The interlaminar insulating substrate known in the art includes, for example, those consisting of rubbers (elastomers), thermosetting resin materials modified with acrylic resin, or thermoplastic resin materials compounded with a large amount of inorganic fillers.

For example, JP-A 2000-183539 discloses "A method of producing a multi-layer insulating substrate using, as an insulating layer, an epoxy-adhered film obtained by compounding non-fibrous inorganic fillers having an average particle diameter of 0.8 to 5 μm with a varnish based on a high-molecular epoxy polymer having an average molecular weight of 50,000 or more obtained by polymerizing a bifunctional epoxy resin and a bifunctional phenol, a multifunctional epoxy resin, a curing agent and a crosslinking agent, and then applying the mixture onto one side or both sides of a substrate."

In the multi-layer insulating substrate according to the production method described above, however, the interfacial area between the inorganic fillers necessary for improvement of physical properties such as mechanical strength and the high-molecular epoxy polymer or the multifunctional epoxy resin is limited, and therefore, a large amount of inorganic fillers should be compounded, thus making it difficult to achieve a thinner interlaminar substrate and causing inconveniences such as an increase in the number of production steps.

Further, the interlaminar insulating substrate using a thin glass cloth or not using a glass cloth has problems such as insufficient heat resistance and dimensional stability and inconveniences such as easy breakage during the production process because of its brittleness.

On the other hand, the polymer material used for industrial purposes should be a material not harmful to the environment because of problems such as disposal of waste plastics and endocrine disrupting chemicals, and thus there is demand for a shift to materials compatible with the environment. Specifically, the shift of halogen-containing flame retardants to non-halogen flame retardants is examined to cope with problems such as generation of dioxins upon combustion. Further, the halogen-containing flame retardants have a strong flame retardant effect with less deterioration in moldability and in physical properties of moldings, but when these flame retardants are used, a large amount of halogen gas may be generated during molding or combustion, and the generated halogen gas causes corrosion of devices or exerts an undesirable effect on the human body, and for safety, there is strong demand for establishment of techniques and methods by using non-halogen flame retardants in place of halogen-containing flame retardants.

As a material for insulating substrate, a material using a non-halogen flame retardant is also developed in recent years for a shift to a material compatible with the environment. However, the non-halogen flame retardant should be incorporated in a large amount in order to exhibit necessary flame retardancy, and thus there is a problem that a material for insulating substrate using the non-halogen flame retardant is inferior in heat resistance and dimensional stability to conventional materials for insulating substrate using a halogen-containing flame retardant.

That is, the problems of such a material for insulating substrate are that the material, when formed into e.g. a thin insulating substrate, hardly maintains heat resistance, dimensional stability and physical properties, and because the non-halogen flame retardant should be compounded in a large amount in order to exhibit necessary flame retardancy, the material hardly attains physical properties and heat resistance required in the production process etc.

### SUMMARY OF THE INVENTION

In view of the foregoing, the object of the present invention is to provide a material for insulating substrate, a printed board, a laminate, copper foil with resin, a copper-clad laminate, a polyimide film, a film for TAB and a prepreg, which are excellent in physical properties, dimensional stability, heat resistance, flame retardancy etc. and exhibit an

excellent flame retardant effect particularly by a shape retention effect at the time of combustion.

A first aspect of the invention is concerned with a material for insulating substrate, which comprises 100 parts by weight of a thermoplastic resin or a mixture of a thermoplastic resin and a thermosetting resin and 0.1 to 100 parts by weight of a layered silicate.

The thermoplastic resin is preferably at least one member selected from the group consisting of polyphenylene ether-based resin, polyphenylene ether-based resin modified with functional groups, a mixture of polyphenylene ether-based resin or polyphenylene ether-based resin modified with functional groups and polystyrene-based resin, alicyclic hydrocarbon-based resin, thermoplastic polyimide-based resin, polyether ether ketone resin, polyether sulfone resin, polyamide imide resin and polyester imide resin.

A second aspect of the invention is concerned with a material for insulating substrate, which comprises 100 parts by weight of at least one thermosetting resin selected from the group consisting of phenol resin, urea resin, unsaturated polyester resin, allyl resin, thermosetting polyimide resin, bismaleimide triazine resin, thermosetting modified polyphenylene ether-based resin, silicon resin and benzooxazine-based resin and 0.1 to 100 parts by weight of a layered silicate.

The material for insulating substrate in the first or second aspect of the invention preferably comprises 0.1 to 100 parts by weight of a flame retardant substantially free of a halogen-based composition.

A third aspect of the invention is concerned with a material for insulating substrate, which comprises 0.1 to 100 parts by weight of a layered silicate and 0.1 to 100 parts by weight of a flame retardant substantially free of a halogen-based composition every 100 parts by weight of epoxy resin.

The flame retardant incorporated into the material for insulating substrate in the first, second or third aspect of the invention is preferably a metal hydroxide or a melamine derivative.

The material for insulating substrate according to the present invention can be prepared by mixing a resin composition (A) containing 100 parts by weight of at least one kind of resin consisting of thermoplastic resin and/or thermosetting resin and 1 to 500 parts by weight of a layered silicate mixed with a resin composition (B) having a composition different from the resin composition (A) and containing at least one kind of thermoplastic resin and/or thermosetting resin. Preferably, the resin composition (A) comprises at least one resin selected from the group consisting of polyamide-based resin, polyphenylene ether-based resin and polyester resin, and the resin composition (B) comprises epoxy-based resin.

The layered silicate incorporated into the material for insulating substrate in the present invention is preferably at least one member selected from the group consisting of montmorillonite, swelling mica and hectorite. The layered silicate preferably comprises an alkyl ammonium ion having 6 or more carbon atoms, and preferably the average interlaminar distance between (001) faces of the layered silicate, as determined by wide-angle X-ray diffractometry, is 3 nm or more, and a part or the whole of the layered silicate is dispersed in 5 or less layers.

In the material for insulating substrate according to the present invention, the yield stress of combustion residues combusted by heating for 30 minutes under the radiant heating condition of 50 $kW/m^2$ in a burning test according to ASTM E 1354 is 4.9 kPa or more upon compression at a rate of 0.1 cm/s.

This invention also encompasses a laminate, a printed board, copper foil with resin, a copper-clad laminate, a polyimide film, a film for TAB, and a prepreg are obtainable by using the material for insulating substrate according to the this invention.

## DETAILED DISCLOSURE OF THE INVENTION

Hereinafter, the present invention is described in detail.

The material for insulating substrate according to the present invention comprises a thermoplastic resin and/or a thermosetting rein.

Examples of the thermoplastic resin include, but are not limited to, polyolefin-based resin, polystyrene-based resin, polyphenylene ether-based resin, and polyphenylene ether-based resin modified with functional groups; a mixture of polyphenylene-based resin or polyphenylene ether-based resin modified with functional groups and a thermoplastic resin such as polystyrene-based resin compatible with polyphenylene ether-based resin or polyphenylene ether-based resin modified with functional groups; alicyclic hydrocarbon-based resin, thermoplastic polyimide-based resin, polyamide imide-based resin, polyester imide-based resin, polyester-based resin, polyether ether ketone (PEEK)-based resin, polyether sulfone resin, polyamide-based resin, polyvinyl acetal-based resin, polyvinyl alcohol-based resin, polyvinyl acetate-based resin, poly(meth)acrylate-based resin and polyoxymethylene-based resin. In particular, polyphenylene ether-based resin, polyphenylene ether-based resin modified with functional groups, a mixture of polyphenylene ether-based resin or polyphenylene ether-based resin modified with functional groups and polystyrene-based resin, alicyclic hydrocarbon-based resin, and thermoplastic polyimide-based resin are preferably used.

These thermoplastic resins may be used alone, or two or more thereof may be simultaneously used. In the present specification, "(meth) acryl" means "acryl" or "methacryl".

The polyphenylene ether-based resin is a polyphenylene ether homopolymer or a polyphenylene ether copolymer consisting of repeating units represented by formula (1):

[Chem. 1]

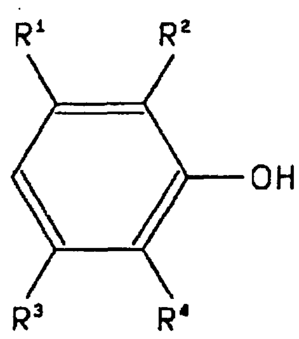

(1)

wherein $R^1$, $R^2$, $R^3$ and $R^4$ each represent a hydrogen atom, alkyl group, aralkyl group, aryl group or alkoxy group. The alkyl group, aralkyl group, aryl group and alkoxy group may be substituted respectively with a substituent group.

Examples of the polyphenylene ether homopolymer include, but are not limited to, poly(2,6-dimethyl-1,4-phenylene) ether, poly(2-methyl-6-ethyl-1,4-phenylene) ether, poly(2,6-diethyl-1,4-phenylene) ether, poly(2-ethyl-6-n-propyl-1,4-phenylene) ether, poly(2,6-di-n-propyl-1,4-phenylene) ether, poly(2-ethyl-6-n-butyl-1,4-phenylene) ether, poly (2-ethyl-6-isobutyl-1,4-phenylene) ether, poly(2-methyl-6-hydroxyethyl-1,4-phenylene) ether etc.

Examples of the polyphenylene ether copolymer include, but are not limited to, copolymers consisting of the above polyphenylene ether repeating units partially containing e.g. alkyl tri-substituted phenol such as 2,3,6-trimethyl phenol and copolymers consisting of these polyphenylene ether copolymers graft-copolymerized with one or more styrene type monomers such as styrene, $\alpha$-methylstyrene and vinyltoluene.

These polyphenylene ether-based resins may be used alone, or two or more polyphenylene ether-based resins different in composition, components or molecular weight may be simultaneously used.

Examples of the polyphenylene ether-based resin modified with functional groups include, but are not limited to, the polyphenylene ether-based resins modified with one or more functional groups such as maleic anhydride group, glycidyl group, amino group, allyl group etc. These polyphenylene ether-based resins modified with functional groups can be used alone, or two or more thereof may be simultaneously used.

When the polyphenylene ether-based resin modified with functional groups is used as the thermoplastic resin, the resulting material for insulating substrate can generate crosslinking reaction to further improve physical properties, heat resistance, dimensional stability etc.

Examples of the mixture of the polyphenylene ether-based resin or the polyphenylene ether-based resin modified with functional groups and polystyrene-based resin include, but are not limited to, a mixture of the polyphenylene ether-based resin or the polyphenylene ether-based resin modified with functional groups and a styrene homopolymer; a mixture of the resin and a copolymer of styrene and one or more styrene type monomers such as $\alpha$-methylstyrene, ethylstyrene, t-butylstyrene, vinyltoluene etc.; and a mixture of the resin and polystyrene-based resin such as styrene-based elastomer. The polystyrene-based resins may be used alone, or two or more thereof may be simultaneously used.

These mixtures of the polyphenylene ether-based resin or the polyphenylene ether-based resin modified with functional groups and polystyrene-based resin may be used alone, or two or more thereof may be simultaneously used.

The alicyclic hydrocarbon-based resin is not particularly limited insofar as it is a hydrocarbon-based resin having a cyclic hydrocarbon group in its polymer chain, and for example, cyclic olefin homopolymers or copolymers are mentioned. These alicyclic hydrocarbon resins may be used alone, or two or more thereof may be simultaneously used.

The cyclic olefin is a norbornene type monomer and includes, for example, norbornene, methanooctahydronaphthalene, dimethanooctahydronaphthalene, dimethanododecahydroanthracene, dimethanodecahydroanthracene, trimethanododecahydroanthracene, dicyclopentadiene, 2,3-dihydrocyclopentadiene, methanooctahydrobenzoindene, dimethanooctahydrobenzoindene, methanodecahydrobenzoindene, dimethanodecahydrobenzoindene, methanooctahydrofluorene, dimethanooctahydrofluorene etc., and substituted derivatives thereof. These cyclic olefins may be used alone, or two or more thereof may be simultaneously used.

Examples of substituent groups on these substituted norbornene derivatives include, but are not limited to, known hydrocarbon groups and polar groups such as alkyl group, alkylidene group, aryl group, cyano group, alkoxycarbonyl group, pyridyl group and halogen atom. These substituent groups may be used alone, or two or more thereof may be simultaneously used.

Examples of the substituted norbornene derivatives include, but are not limited to, 5-methyl-2-norbornene, 5,5-dimethyl-2-norbornene, 5-ethyl-2-norbornene, 5-butyl-2-norbornene, 5-ethylidene-2-norbornene, 5-methoxycarbonyl-2-norbornene, 5-cyano-2-norbornene, 5-methyl-5-methoxycarbonyl-2-norbornene, 5-phenyl-2-norbornene, 5-phenyl-5-methyl-2-norbornene etc. These norbornene derivatives may be used alone, or two or more thereof may be simultaneously used.

The alicyclic hydrocarbon-based resin is commercially available, for example, as Arton$^{TM}$ series manufactured by JSR and Zeonor$^{TM}$ series manufactured by Nippon Zeon Co., Ltd.

Examples of the thermoplastic polyimide-based resin include, but are not limited to, polyether imide resin having an imide linkage and an ether linkage in a main chain of the molecule, polyamide imide resin having an imide linkage and an amide linkage in a main chain of the molecule, and polyester imide resin having an imide linkage and an ester linkage in a main chain of the molecule. These thermoplastic polyimide-based resins may be used alone, or two or more thereof may be simultaneously used.

Examples of the polyether ether ketone resin include, but are not limited to, reaction products obtained by polycondensating dihalogenobenzophenone with hydroquinone.

The thermosetting resin is a resin made of a relatively low molecular material, which is in a liquid, semi-liquid or solid form at ordinary temperatures, shows fluidity at ordinary temperatures or under heating, and generates chemical reaction such as curing reaction or crosslinking reaction by the action of a curing agent, a catalyst or heating, to form a three-dimensional network structure to make itself insoluble and non-fusible.

Examples of the thermosetting resin include, but are not limited to, phenol-based resin, epoxy-based resin, unsaturated polyester-based resin, alkyd-based resin, furan-based resin, urea-based resin, melamine-based resin, polyurethane-based resin, aniline-based resin, thermosetting modified polyphenylene ether-based resin, thermosetting polyimide-based resin, allyl resin, bismaleimide triazine resin, silicon resin, benzooxazine-based resin etc. Particularly preferably used among these resins are epoxy-based resin, phenol resin, urea resin, unsaturated polyester resin, allyl resin, thermosetting polyimide resin, bismaleimide triazine resin, thermosetting modified polyphenylene ether-based resin, silicon resin and benzooxazine-based resin. These thermosetting resins may be used alone, or two or more thereof may be simultaneously used.

The epoxy resin refers to an organic compound having at least one oxirane ring (epoxy group). The number of epoxy groups in the epoxy resin is preferably one or more per molecule, more preferably two or more per molecule. The number of epoxy groups per molecule is determined by dividing the number of epoxy groups in the epoxy resin by the number of molecules in the epoxy resin.

Examples of the epoxy resin include, but are not limited to, conventionally known epoxy resins, for example epoxy resins (1) to (11) shown below. These epoxy resins may be used alone, or two or more thereof may be simultaneously used.

The epoxy resin (1) include bisphenol type epoxy resins such as bisphenol A type epoxy resin, bisphenol F type epoxy resin, bisphenol AD type epoxy resin, bisphenol S type epoxy resin etc.; novolak type epoxy resins such as phenol novolak type epoxy resin, cresol novolak type epoxy resin etc.; aromatic epoxy resins such as trisphenolmethane triglycidyl ether etc., and hydrogenated derivatives thereof and bromides thereof.

The epoxy resin (2) includes alicyclic epoxy resins such as 3,4-ethoxycyclohexylmethyl-3,4-epoxycyclohexane carboxylate, 3,4-epoxy-2-methylcyclohexylmethyl-3,4-epoxy-2-methylcyclohexane carboxylate, bis(3,4-epoxycyclohexyl) adipate, bis(3,4-epoxycyclohexylmethyl) adipate, bis(3,4-epoxy-6-methylcyclohexylmethyl) adipate, 2-(3,4-epoxycyclohexyl-5,5-spiro-3,4-epoxy) cyclohexanone-meth-dioxane, bis(2,3-epoxycyclopentyl) ether etc. Commercial products of the epoxy resin (2) include, for example, EHPE-3150$^{TM}$ (softening temperature of 71°C, Daicel Chemical Industries, Ltd.).

The epoxy resin (3) includes aliphatic epoxy resins of long-chain polyol polyglycidyl ethers such as 1,4-butanediol diglycidyl ether, 1,6-hexanediol diglycidyl ether, glycerine triglycidyl ether, trimethylolpropane triglycidyl ether, polyethylene glycol diglycidyl ether, polypropylene glycol diglycidyl ether, a polyoxylalkylene glycol containing an alkylene group having 2 to 9 carbon atoms (preferably 2 to 4), and polytetramethylene ether glycol.

The epoxy resin (4) includes glycidyl ester type epoxy resins such as diglycidyl phthalate, diglycidyl tetrahydrophthalate, diglycidyl hexahydrophthalate, diglycidyl-p-oxybenzoic acid, glycidylether-glycidyl salicylate, glycidyl dimer acid ester etc. and hydrogenated derivatives thereof.

The epoxy resin (5) includes glycidylamine epoxy resins such as triglycidyl isocyanurate, cyclic alkylene urea N,N'-diglycidyl derivatives, p-aminophenol N,N,O-triglycidyl derivatives, m-aminophenol N,N,O-triglycidyl derivatives, and hydrogenated derivatives thereof.

The epoxy resin (6) includes copolymers of glycidyl (meth) acrylate with radical polymerizable monomers

such as ethylene, vinyl acetate, (meth) acrylate etc.

The epoxy resin (7) includes resins produced by epoxylation of unsaturated carbon-carbon double bonds in polymers based on conjugated diene compounds such as epoxylated polybutadiene or in partially hydrogenated derivatives of the polymers.

The epoxy resin (8) includes resins produced by epoxylation of unsaturated carbon-carbon double bonds in conjugated diene compounds such as block copolymers (e.g. epoxylated SBS) having "a polymer block based on a vinyl aromatic compound" and "a polymer block based on a conjugated diene compound or a polymer block of a partially hydrogenated derivative thereof" in the same molecule.

The epoxy resin (9) is a polyester resin having one or more epoxy groups, preferably two or more epoxy groups, per molecule.

The epoxy resin (10) is an urethane-modified epoxy resin or a polycaprolactone-modified epoxy resin produced by introducing urethane linkages or polycaprolactone linkages into a structure of the epoxy resin described above.

The epoxy resin (11) is a rubber-modified epoxy resin produced by incorporating a rubber component such as NBR, CTBN, polybutadiene or acrylic rubber into the epoxy resin described above.

The curing agent used in the epoxy resin is not particularly limited, and examples thereof include a wide variety of known curing agents for epoxy resin, such as an amine compound, a compound such as a polyaminoamide compound synthesized from the amine compound, a tertiary amine compound, an imidazole compound, a hydrazide compound, dicyanamide and derivatives thereof, a melamine compound, an acid anhydride, a phenol compound, a thermal latent cation polymerization catalyst, an optical latent cation polymerization initiator etc. These curing agents can be used alone, or two or more thereof may be simultaneously used.

The amine compound includes, for example, linear fatty amines such as ethylene diamine, diethylene triamine, triethylene tetramine, tetraethylene pentamine, polyoxypropylene diamine, polyoxypropylene triamine etc., and derivatives thereof; cyclic fatty amines such as mencene diamine, isophorone diamine, bis(4-amino-3-methylcyclohexyl) methane, diaminodicyclohexyl methane, bis (aminomethyl) cyclohexane, N-aminoethyl piperazine, 3, 9-bis (3-aminopropyl) -2, 4, 8, 10-tetraoxaspiro (5,5) undecane etc. and derivatives thereof; aromatic amines such as m-xylene diamine, α-(m/p-aminophenyl) ethylamine, m-phenylene diamine, diaminodiphenyl methane, diaminodiphenyl sulfone, α,α-bis (4-aminophenyl)-p-diisopropyl benzene etc. and derivatives thereof.

Compounds such as the polyaminoamide compound synthesized from the amine compound include, for example, polyaminoamide compounds synthesized from the various amine compounds described above and carboxylic acid compounds such as succinic acid, adipic acid, azelaic acid, sebacic acid, dodecadiacid, isophthalic acid, terephthalic acid, dihydroisophthalic acid, tetrahydroisophthalic acid, hexahydroisophthalic acid etc. and derivatives thereof; polyaminoimide compounds synthesized from the amine compounds and maleimide compounds such as diaminodiphenylmethane bismaleimide etc. and derivatives thereof; ketimine compounds synthesized from the amine compounds and ketone compounds and derivatives thereof; and polyamino compounds synthesized from the amine compounds and compounds such as epoxy compound, urea, thiourea, aldehyde compound, phenol compound, and acrylic compound and derivatives thereof.

The tertiary amine compound includes, for example, N,N-dimethyl piperazine, pyridine, picoline, benzyldimethyl amine, 2-(dimethylaminomethyl) phenol, 2,4,6-tris(dimethylaminomethyl) phenol, 1,8-diazabiscyclo (5,4,0) undecene-1 and derivatives thereof.

The imidazole compound includes, for example, 2-methylimidazole, 2-ethyl-4-methylimidazole, 2-undecylimidazole, 2-heptadecylimidazole, 2-phenylimidazole and derivatives thereof.

The hydrazide compound includes, for example, 1,3-bis(hydrazinocarboethyl)-5-isopropylhydantoin, 7,11-octadecadiene-1,18-dicarbohydrazide, eicosane diacid dihydrazide, adipic acid dihydrazide and derivatives thereof.

The melamine compound includes, for example, 2,4-diamino-6-vinyl-1,3,5-triazine and derivatives thereof.

The acid anhydride includes, for example, phthalic anhydride, trimellitic anhydride, pyromellitic anhydride, benzophenone tetracarboxylic anhydride, ethylene glycol bisanhydrotrimellitate, glycerol trisanhydrotrimellitate, methyltetrahydrophthalic anhydride, tetrahydrophthalic anhydride, nadic anhydride, methyl nadic anhydride, trialkyltetrahydrophthalic anhydride, hexahydrophthalic anhydride, methylhexahydrophthalic anhydride, 5-(2,5-dioxotetrahydrofuryl)-3-methyl-3-cyclohexene-1, 2-dicarboxylic anhydride, trialkyltetrahydrophthalic anhydride-maleic anhydride adduct, dodecenylsuccinic anhydride, polyazelaic anhydride, polydodecane diacid anhydride, Chlorendic acid anhydride and derivatives thereof.

The phenol compound includes, for example, phenol novolak, o-cresol novolak, p-cresol novolak, t-butyl phenol novolak, dicyclopentadiene cresol and derivatives thereof.

The thermal latent cation polymerization catalyst includes, for example, ionic thermal latent cation polymerization catalysts such as benzyl sulfonium salt, benzyl ammonium salt, benzyl pyridinium salt and benzyl phosphonium salt, having antimony hexafluoride, phosphorus hexafluoride or boron tetrafluoride as the counter anion; and nonionic thermal latent cation polymerization catalysts such as N-benzyl phthalimide, aromatic sulfonate etc.

The optical latent cation polymerization initiator includes, for example, ionic optical latent cation polymerization initiators, for example onium salts such as an aromatic diazonium salt, aromatic halonium salt and aromatic sulfonium salt having antimony hexafluoride, phosphorus hexafluoride or boron tetrafluoride as the counter anion, and organometallic complexes such as iron-arene complex, titanocene complex, aryl silanol-aluminum complex etc.; and nonionic optical latent cation polymerization initiators such as nitrobenzyl ester, sulfonic acid derivatives, phosphates, phenol sulfonates, diazonaphthoquinone, N-hydroxyimide sulfonate etc.

Examples of the thermosetting modified polyphenylene ether-based resin include, but are not limited to, resins obtained by modifying the polyphenylene ether-based resin with thermosetting functional groups such as glycidyl group, isocyanate group and amino group. These thermosetting modified polyphenylene ether-based resins may be used alone, or two or more thereof may be simultaneously used.

The thermosetting polyimide-based resin is a resin having imide linkages in a main chain of the molecule, and examples thereof include, but are not limited to, aromatic diamine/aromatic tetracarboxylic acid condensation polymer, bismaleimide resins such as aromatic diamine/bismaleimide addition polymer, polyaminobismaleimide resins such as aminobenzoic acid hydrazide/bismaleimide addition polymer, and bismaleimide triazine resin consisting of a dicyanate compound and bismaleimide resin. In particular, the bismaleimide triazine resin can be preferably used. These thermosetting polyimide-based resins may be used alone, or two or more thereof may be simultaneously used.

The urea resin is not particularly limited insofar as it is a thermosetting resin obtained by addition condensation reaction of urea with formaldehyde. Examples of curing agents used in the curing reaction of the urea resin include, but are not limited to, tangible curing agents consisting of an inorganic acid, an organic acid or an acidic salt such as acidic sodium sulfate; and latent curing agents such as carboxylate, acid anhydrides, and salts such as ammonium chloride, ammonium phosphate etc. In particular, the latent curing agent is preferable in respect of shelf stability etc.

The allyl resin is not particularly limited insofar as it is obtained by polymerization and curing reaction of diallyl phthalate monomers. The dialkyl phthalates monomers include for example ortho-, iso- and tere-monomers. As the curing catalyst at the time of curing, for example, t-butyl perbenzoate and di-t-butyl peroxide are simultaneously used.

The silicon resin contains a silicon-silicon bond, silicon-carbon bond, siloxane bond and silicon-nitrogen bond in the molecule, and for example, polysiloxane, polycarbosilane and polysilazane can be mentioned.

The benzooxazine resin is obtained by ring-opening polymerization of an oxazine ring of a benzooxazine monomer. Examples of the benzooxazine monomer include, but are not limited to, benzooxazine monomers having a functional group such as phenyl group, methyl group or cyclohexyl group bound to nitrogen of the oxazine ring thereof.

To improve the characteristics of the resin, the thermoplastic resin and/or thermosetting resin may be compounded with thermoplastic elastomers, crosslinked rubber, oligomers etc. if necessary in such a range that the object of the invention is achieved. Further, these may be used alone or simultaneously.

Examples of the thermoplastic elastomers include, but are not limited to, styrene elastomer, olefin elastomer, urethane elastomer and polyester elastomer. These thermoplastic elastomers may be used alone, or two or more thereof may be simultaneously used.

Examples of the crosslinked rubber include, but are not limited to, isoprene rubber, butadiene rubber, 1,2-polybutadiene, styrene-butadiene rubber, nitrile rubber, butyl rubber, ethylene-propylene rubber, silicone rubber and urethane rubber. To improve the compatibility thereof with the resin, these crosslinked rubbers are used preferably after modification with functional groups. These crosslinked rubbers may be used alone, or two or more thereof may be simultaneously used.

Examples of the oligomers include, but are not limited to, maleic anhydride-modified polyethylene oligomers. These oligomers may be used alone, or two or more thereof may be simultaneously used.

The thermoplastic resin and/or thermosetting resin may be compounded with one or more additives such as nucleating agents capable of serving as crystal core for making fine crystals, antioxidants (aging inhibitors), heat stabilizers, light stabilizers, UV absorbers, lubricants, flame retardants, antistatic agents and anti-fogging agents as an auxiliary means of achieving uniform physical properties.

The material for insulating substrate in the present invention comprises the thermoplastic resin and/or thermosetting resin and layered silicates.

The layered silicates refer to silicate minerals having exchangeable metal cations between layers thereof.

Examples of the layered silicates include, but are not limited to, smectite clay minerals such as montmorillonite, saponite, hectorite, beidellite, stevensite and nontronite, vermiculite, halloysite, and swelling mica. In particular, montmorillonite and/or swelling mica and/or hectorite are preferably used. The layered silicates may be a naturally occurring material or a synthetic material. These layered silicates may be used alone, or two or more thereof may be simultaneously used.

The layered silicate is preferably a smectite clay mineral or swelling mica whose shape anisotropic effect defined by the equation (2) below is high. By using the layered silicate having a high shape anisotropic effect, the material for insulating substrate according to the present invention attains more excellent physical properties.

Equation (2): Shape anisotropic effect = Area of crystal surface (A) /area of crystal surface (B)

wherein the crystal surface (A) means the front of a layer, and the crystal surface (B) means a side of the layer.

The shape of the layered silicate is not particularly limited, but the average length thereof is preferably 0.01 to 3 μm, more preferably 0.05 to 2 μm. The thickness is preferably 0.001 to 1 μm, more preferably 0.01 to 0.5 μm. The aspect ratio is preferably 20 to 500, more preferably 50 to 200.

The exchangeable cations present between layers of the layered silicate are metal ions such as sodium and calcium present on the crystal surface of the layered silicate, and these metal ions have cation exchangeability with cationic materials and can thus be inserted (intercalated) between crystal layers of the layered silicate.

The cation exchange capacity of the layered silicate is not particularly limited, but is preferably 50 to 200 milli-equivalent/100 g. If the cation exchange capacity of the layered silicate is less than 50 milli-equivalent/100 g, the amount of cationic materials intercalated between crystal layers of the layered silicate by cation exchange is reduced, which may result in failure to achieve sufficient non-polarization (hydrophobilization) between the crystal layers, while if the cation exchange capacity is higher than 200 milli-equivalent/100 g, the bond strength between the crystal layers of the layered silicate is too strong, which may results in difficult release of a thin crystal layer.

When a low-polar resin, such as polyphenylene ether-based resin, is used as the thermoplastic resin and/or thermosetting resin in the present invention, previous hydrophobilization between layers of the layered silicate by cation exchange with a cationic surfactant is preferable. By previous hydrophobilization between layers of the layered silicate, the affinity of the layered silicate for the low-polar thermoplastic resin or thermosetting resin is improved, and thus the layered silicate can be finely dispersed more uniformly in the low-polar thermoplastic resin and/or thermosetting resin.

Examples of the cationic surfactant include, but are not limited to, quaternary ammonium salt, quaternary phosphonium salt etc. In particular, quaternary ammonium salts having an alkyl chain having 6 or more carbon atoms (alkyl ammonium salts having 6 or more carbon atoms) are preferably used because these salts can achieve non-polarization (hydrophobilization) between the crystal layers of the layered silicate.

Examples of the quaternary ammonium salts include, but are not limited to, trimethylalkyl ammonium salt, triethylalkyl ammonium salt, tributylalkyl ammonium salt, dimethyldialkyl ammonium salt, dibutyldialkyl ammonium salt, methylbenzyldialkyl ammonium salt, dibenzyldialkyl ammonium salt, trialkylmethyl ammonium salt, trialkylethyl ammonium salt, trialkylbutyl ammonium salt, quaternary ammonium salt having an aromatic ring, quaternary ammonium salt derived from an aromatic amine, such as trimethylphenyl ammonium, dialkyl quaternary ammonium salt having two polyethylene glycol chains, dialkyl quaternary ammonium salt having two polypropylene glycol chains, trialkyl quaternary ammonium salt having one polyethylene glycol chain, and trialkyl quaternary ammonium salt having one polypropylene glycol chain. Particularly preferable among these salts are lauryltrimethyl ammonium salt, stearyltrimethyl ammonium salt, trioctylmethyl ammonium salt, distearyldimethyl ammonium salt, di-hardened tallow dimethyl ammonium salt, distearyldibenzyl ammonium salt, and N-polyoxyethylene-N-lauryl-N,N-dimethyl ammonium salt. These quaternary salts may be used alone, or two or more thereof may be simultaneously used.

Examples of the quaternary phosphonium salt include, but are not limited to, dodecyltriphenyl phosphonium salt, methyltriphenyl phosphonium salt, lauryltrimethyl phosphonium salt, stearyltrimethyl phosphonium salt, trioctylphosphonium salt, distearyldimethyl phosphonium salt, distearyldibenzyl phosphonium salt etc. These quaternary phosphonium salts may be used alone, or two or more thereof may be simultaneously used.

The dispersibility, in thermoplastic resin and/or thermosetting resin, of the layered silicate used in the present invention can be improved by the chemical treatment described above.

The chemical treatment is not limited to the method of cation exchange with a cationic surfactant (also referred to hereinafter as chemical modification method (1)), and the treatment can also be carried out using various chemical methods shown in e.g. chemical modification methods (2) to (6) below. These chemical modification methods may be used alone, or two or more thereof may be simultaneously used.

The layered silicate whose dispersibility in thermoplastic resin and/or thermosetting resin is improved by the various chemical methods including the chemical modification method (1) is also referred to hereinafter as "organized layered silicate".

The chemical modification method (2) is a method of chemically treating hydroxyl groups present on the crystal surface of the organized layered silicate treated chemically with the chemical modification method (1), with a compound having, in its terminal, one or more functional groups capable of chemically binding thereto or one or more functional groups not chemically binding thereto but having high chemical affinity therefor.

The chemical modification method (3) is a method of chemically treating hydroxyl groups present on the crystal surface of the organized layered silicate treated chemically with the chemical modification method (1), with a compound having, in its terminal, one or more functional groups not chemically binding thereto but having high chemical affinity therefor and one or more reactive functional groups.

The chemical modification method (4) is a method of chemically treating the crystal surface of the organized

layered silicate treated chemically with the chemical modification method (1), with an anionic surface active compound.

The chemical modification method (5) is a method according to the chemical modification method (4), which comprises chemical treatment with an anionic surface active compound having one or more reactive functional groups in addition to anionic sites in its molecular chain.

The chemical modification method (6) is a method of using a composition containing a resin (e.g. maleic anhydride-modified polyphenylene ether-based resin) having functional groups capable of reacting with the organized layered silicates chemically treated previously with any of the chemical modification methods (1) to (5).

In the chemical modification method (2), the functional groups capable of chemically binding to hydroxyl groups, or the functional groups not chemically binding thereto but having high chemical affinity therefor, are not particularly limited, and examples thereof include functional groups such as alkoxy group, glycidyl group, carboxyl group (including dibasic acid anhydrides), hydroxyl group, isocyanate group and aldehyde group, and other functional groups having high affinity for hydroxyl group. The compound having functional groups chemically binding to hydroxyl groups or functional groups not chemically binding thereto but having high chemical affinity therefor includes, but is not limited to, compounds having the above functional groups, for example silane compounds, titanate compounds, glycidyl compounds, carboxylic acids and alcohols. These compounds may be used alone, or two or more thereof may be simultaneously used.

Examples of the silane compounds include, but are not limited to, vinyltrimethoxysilane, vinyltriethoxysilane, vinyltris(β-methoxyethoxy)silane, γ-aminopropyltrimethoxysilane, γ-aminopropylmethyldimethoxysilane, γ-aminopropyldimethylmethoxysilane, γ-aminopropyltriethoxysilane, γ-aminopropylmethyldiethoxysilane, γ-aminopropyldimethylethoxysilane, methyltriethoxysilane, dimethyldimethoxysilane, trimethylmethoxysilane, hexyltrimethoxysilane, hexyltriethoxysilane, N-β-(aminoethyl)- γ-aminopropyltrimethoxysilane, N-β-(aminoethyl)- γ-aminopropyltriethoxysilane, N-β-(aminoethyl)-γ-aminopropylmethyldimethoxysilane, octadecyltrimethoxysilane, octadecyltriethoxysilane, γ-methacryloxypropylmethyldimethoxysilane, γ-methacryloxypropylmethyldiethoxysilane, γ-methacryloxypropyltrimethosysilane, and γ-methacryloxypropyltriethoxysilane. These silane compounds may be used alone, or two or more thereof may be simultaneously used.

In the chemical modification methods (4) and (5), the anionic surface active compound, and the anionic surface active compound having one or more reactive functional groups in addition to anionic sites in its molecular chain, are not particularly limited insofar as they are compounds capable of chemically treating the layered silicate by ionic interaction, and examples thereof include sodium laurate, sodium stearate, sodium oleate, higher alcohol sulfates, secondary higher alcohol sulfates, unsaturated alcohol sulfates etc. These compounds may be used alone, or two or more thereof may be simultaneously used.

The layered silicate is preferably a layered silicate wherein the average interlaminar distance of the (001) face, as determined by wide-angle X-ray diffractometry, is 3 nm or more, and a part or the whole of the layered silicate is dispersed in 5 or less layers, more preferably a layered silicate wherein the average interlaminar distance is 3 to 5 nm, and a part or the whole of the layered silicate is dispersed in 5 or less layers. In the present description, the average interlaminar distance of the layered silicate means an average distance between fine, thin crystal layers of the layered silicate, and can be determined by a method of using X-ray diffraction peak and photographing with a transmittance electron microscope, that is, by wide-angle X-ray diffractometry.

The fact that the average interlaminar distance of the layered silicate is 3 nm or more means that the layered silicate is cleaved into separate layers apart by 3 nm or more, and the fact that a part or the whole of the layered silicate is dispersed in 5 or less layers means that a part or the whole of the layered silicate as a laminate is dispersed. These facts mean that the interlaminar interaction of the layered silicate is weakened.

When the average interlaminar distance of the layered silicate is 3 nm or more and simultaneously a part or the whole of the layered silicate is dispersed in 5 or less layers, the material for insulating substrate in the present invention obtained by compounding and dispersing the layered silicate in the thermoplastic resin and/or thermosetting resin exhibits excellent performance in flame retardancy, physical properties, heat resistance and dimensional stability. When the average interlaminar distance is less than 3 nm, the effect of the layered silicate dispersed on the nanometer scale cannot be sufficiently obtained, thus limiting the improvements in physical properties and flame retardancy to those achieved by compounding with usual inorganic fillers. The average interlaminar distance is more preferably 3 to 5 nm. When the average interlaminar distance is greater than 5 nm, all thin crystal layers of the layered silicate are separated from one another to reduce the interaction of the layered silicate to a negligible level thus lowering the rate of formation of a coating upon combustion, which may result in failure to achieve sufficient improvements in flame retardancy.

The fact that a part or the whole of the layered silicate is dispersed in 5 or less layers means, specifically, that preferably 10% or more, more preferably 20% or more, of the layered silicate is dispersed in 5 or less layers.

The percentage of the layered silicate dispersed in 5 or less layers can be determined by observing a dispersed state of the layered silicate at 50,000× to 100,000× magnification under a transmission electron microscope, determining the number of aggregated layers (Y) dispersed in 5 or less layers/the number of total aggregated layers (X) of

the layered silicate observable in a predetermined area, and calculating the percentage from the following equation (3):

$$\text{Equation (3): Percentage (\%) of the layered silicate dispersed in 5 or less layers} = (Y/X) \times 100$$

The layered silicate is separated preferably into 5 or less layers in order to achieve the above-mentioned effect, more preferably into 3 or less layers, still more preferably in a single layer.

In the material for insulating substrate in the present invention, when the average interlaminar distance of the layered silicate is 3 nm or more and simultaneously a part or the whole of the layered silicate is dispersed in 5 or less layers, that is, when the layered silicate is highly dispersed in the thermoplastic resin and/or thermosetting resin, the interfacial area between the thermoplastic resin and/or thermosetting resin and the layered silicate is increased, and the average distance between the crystal thin layers of the layered silicate is decreased.

When the interfacial area between the thermoplastic resin and/or thermosetting resin and the layered silicate is increased, the binding of the thermoplastic resin and/or thermosetting resin to the surface of the layered silicate is increased, thus improving physical properties such as elastic modulus etc. Further, when the binding of the thermoplastic resin and/or thermosetting resin to the surface of the layered silicate is increased, the melt viscosity is increased, thus improving moldability. Because gas molecules, as compared with the inorganic material, diffuse very easily into the polymer, and therefore, gas molecules when diffusing into the thermoplastic resin and/or thermosetting resin can diffuse around the inorganic material, to exhibit gas barrier properties.

On the other hand, when the average distance between thin crystal layers of the layered silicate is decreased, the material for insulating substrate easily forms a sintered body of thin crystal layers of the layered silicate gathering upon combustion. That is, the material for insulating substrate wherein thin crystal layers of the layered silicate are dispersed such that the average interlaminar distance is 3 nm or more easily forms a sintered body capable of serving as a flame retardant coating. This sintered body is formed at an earlier stage of combustion, thus not only cutting off supply of oxygen from the outside but also cutting off combustible gas generated during combustion, to permit the material for insulating substrate to exhibit excellent flame retardancy.

The material for insulating substrate in the first aspect of the invention comprises 0.1 to 100 parts by weight of the layered silicate every 100 parts by weight of the thermoplastic resin or a mixture of the thermoplastic resin and the thermosetting resin.

The material for insulating substrate in the second aspect of the invention comprises 0.1 to 100 parts by weight of the layered silicate every 100 parts by weight of the thermosetting resin.

The material for insulating substrate in the third aspect of the invention comprises 0.1 to 100 parts by weight of the layered silicate every 100 parts by weight of the epoxy resin.

If the content of the layered silicate in 100 parts by weight of the thermoplastic resin and/or thermosetting resin is less than 0.1 part, its effect of improving flame retardancy or physical properties is lowered, while if the content is greater than 100 parts by weight, the material for insulating substrate is poor in practical use because the density (specific gravity) thereof is increased and simultaneously the mechanical strength is decreased. The content is preferably 1 to 50 parts by weight, more preferably 5 to 20 parts by weight. If the content is less than 1 part by weight, the material for insulating substrate in the present invention may fail to exhibit its sufficient flame retardant effect when molded in a thin film, while if the content is greater than 50 parts by weight, moldability may be lowered. When the content is 5 to 20 parts by weight, its sufficient flame retardant effect can be achieved without any problems in mechanical physical properties and processability.

The method of dispersing the layered silicate in the thermoplastic resin and/or thermosetting resin includes, but is not limited to, a method of using the organized layered silicate, a method of mixing the thermoplastic resin and/or thermosetting resin with the layered silicate in a usual manner and then foaming the mixture, or a method of using a dispersant. By using these dispersing methods, the layered silicate can be dispersed more uniformly and finely in the thermoplastic resin and/or thermosetting resin.

The method of mixing the thermoplastic resin and/or thermosetting resin with the layered silicate in a usual manner and then foaming the mixture is a method of using a foaming agent to foam the thermoplastic resin and/or thermosetting resin and converting the foaming energy into energy for dispersing the layered silicate.

Examples of the foaming agent include, but are not limited to, a gaseous foaming agent, an easily volatile liquid foaming agent and a thermally degradable solid foaming agent. These foaming agents can be used alone, or two or more thereof can be simultaneously used.

The method of foaming the thermoplastic resin and/or thermosetting resin in the presence of the layered silicate thereby dispersing the layered silicate in the thermoplastic resin and/or thermosetting resin includes, but is not limited to, a method of impregnating a resin composition consisting of 100 parts by weight of the thermoplastic resin and/or thermosetting resin and 0.1 to 100 parts by weight of the layered silicate with a gaseous foaming agent under high pressure and then gasifying the gaseous foaming agent in the resin composition thereby forming a foam, or a

method of incorporating a thermally degradable foaming agent into between layers of the layered silicate and degrading the thermally degradable foaming agent by heating to form a foam.

Preferably, the material for insulating substrate according to this invention contains a flame retardant substantially free of a halogen composition.

Given the phrase "substantially free of a halogen composition", it is meant that because of the production process, contamination with a very small amount of halogen is allowable.

Examples of the flame retardant include, but are not limited to, metal hydroxides such as aluminum hydroxide, magnesium hydroxide, dosonite, calcium aluminate, gypsum dihydrate and calcium hydroxide; metal oxides; phosphorus compounds such as red phosphorus and ammonium polyphosphate; layered complex hydrates such as nitrogenous compounds including melamine and melamine derivatives, for example, melamine cyanurate, melamine isocyanurate and melamine phosphate, each of which may be subjected to surface treatment, fluorine resin, silicone oil and hydrotalcite; and silicone-acrylic composite rubber. In particular, metal hydroxides and melamine derivatives are preferably used.

Particularly preferable among the metal hydroxides are magnesium hydroxide and aluminum hydroxide, which may be subjected to surface treatment with various surface treatment agents. Examples of the surface treatment agents include, but are not limited to, silane coupling agents, titanate coupling agents, PVA surface treatment agents, epoxy surface treatment agents, etc. These flame retardants may be used alone, or two or more thereof may be simultaneously used.

When the flame retardant is a metal hydroxide, the content thereof in the material for insulating substrate in the first aspect of the invention is preferably 0.1 to 100 parts by weight relative to 100 parts by weight of the thermoplastic resin or a mixture of the thermoplastic resin and thermosetting resin; the content thereof in the material for insulating substrate in the second aspect of the invention is preferably 0.1 to 100 parts by weight relative to 100 parts by weight of the thermosetting resin; and the content of the flame retardant in the material for insulating substrate in the third aspect of the invention is preferably 0.1 to 100 parts by weight relative to 100 parts by weight of the epoxy resin. If the content is less than 0.1 part by weight, the effect of the flame retardant may not be sufficiently obtained, while if the content is greater than 100 parts by weight, the density (specific gravity) of the material for insulating substrate may be too high to be practically used, or the flexibility and elongation may be significantly deteriorated. The content is more preferably 5 to 80 parts by weight, more preferably 10 to 70 parts by weight. When the content is less than 5 parts by weight, the effect of the flame retardant may not be sufficiently achieved in the case of a thin insulating substrate, while if the amount is greater than 80 parts by weight, the percentage of rejects may be increased due to swelling in the process at high temperatures. An amount in the range of 10 to 70 parts by weight is preferable because sufficient flame retardancy can be achieved without any problems in mechanical physical properties, electrical physical properties and processability.

When the flame retardant is a melamine derivative, the content thereof in the material for insulating substrate in the first aspect of the invention is preferably 0.1 to 100 parts by weight based on 100 parts by weight of the thermoplastic resin or a mixture of the thermoplastic resin and thermosetting resin. The content thereof in the material for insulating substrate in the second aspect of the invention is preferably 0.1 to 100 parts by weight based on 100 parts by weight of the thermosetting resin. The content of the flame retardant in the material for insulating substrate in the third aspect of the invention is 0.1 to 100 parts by weight based on 100 parts by weight of the epoxy resin. If the content is less than 0.1 part by weight, the effect of the flame retardant may not be sufficiently achieved, while if the content is greater than 100 parts by weight, mechanical physical properties such as flexibility and elongation may be extremely deteriorated. The content is more preferably 5 to 70 parts by weight, more preferably 10 to 50 parts by weight. If the content is less than 5 parts by weight, the effect of the flame retardant may not be sufficiently obtained when the insulating film is made thin, while if the content is greater than 70 parts by weight, mechanical physical properties such as flexibility and elongation may be extremely deteriorated. A content of the flame retardant in the range of 10 to 70 parts by weight is preferable because sufficient flame retardancy can be achieved without any problems in mechanical physical properties, electrical physical properties, and processability.

The material for insulating substrate in the present invention may be compounded if necessary with one or more additives such as fillers, softeners, plasticizers, lubricants, antistatic agents, anti-fogging agents, coloring agents, antioxidants (aging inhibitors), heat stabilizers, light stabilizers and UV absorbers in such a range that the object of this invention can be achieved.

The method of producing the material for insulating substrate in the present invention includes, but is not limited to, a method (direct kneading method) which comprises directly compounding predetermined amounts of the thermoplastic resin and/or the thermosetting resin and the layered silicate and if necessary predetermined amounts of one or more additives and then kneading the mixture at ordinary temperature or under heating, or a method of mixing them in a solvent and then removing the solvent. Alternatively, there is a method (master batch method) which comprises compounding a larger amount of the layered silicate with the thermoplastic resin and/or thermosetting resin, kneading the mixture to prepare a master batch, and kneading the master batch with the remainder of the thermoplastic

resin and/or thermosetting resin and if necessary with predetermined amounts of one or more additives, at ordinary temperature or under heating, or mixing them in a solvent.

The concentration of the layered silicate in the master batch is not particularly limited, but the amount thereof is preferably 1 to 500 parts by weight, more preferably 5 to 300 parts by weight, relative to 100 parts by weight of the thermoplastic resin and/or thermosetting resin. If the amount is less than 1 part by weight, the advantage of the master batch, that is, the ability to be diluted to any arbitrary concentrations, may be lost, while if the amount is greater than 500 parts by weight, the dispersibility of the master batch itself or the dispersibility of a predetermined amount of the layered silicate upon dilution in the thermoplastic resin and/or thermosetting resin may be deteriorated.

In the master batch method, the resin composition (A) (master batch) having the layered silicate compounded with the thermoplastic resin and/or thermosetting resin may have a composition which is identical with or different from the resin composition (B) comprising the thermoplastic resin and/or thermosetting resin used for diluting the master batch to a predetermined concentration of the layered silicate.

The resin composition (A) preferably comprises at least one resin selected from the group consisting of polyamide-based resin, polyphenylene ether-based resin, polyether sulfone-based resin and polyester resin in which the layered silicate can be easily dispersed, and the resin composition (B) preferably comprises epoxy resin which is inexpensive and excellent in electrical characteristics and physical properties at high temperatures.

The material for insulating substrate prepared by the master batch method also constitutes one aspect of the invention.

When the thermoplastic resin is used as the resin, it is possible to use a method wherein the layered silicate containing a polymerization catalyst (polymerization initiator) such as a transition-metal complex is kneaded with monomers constituting the thermoplastic resin and the monomers are polymerized so that polymerization of the thermoplastic resin and production of the material for insulating material are simultaneously carried out.

When the thermosetting resin is used as the resin, it is possible to use a method wherein the layered silicate containing a curing agent (crosslinking agent) such as amine is kneaded with a starting resin material constituting the thermosetting resin and the starting resin material is cured (crosslinked) so that curing (crosslinking) of the thermosetting resin and production of the material for insulating material are simultaneously carried out.

In the method of producing the material for insulating substrate by the direct kneading method or the master batch method in the present invention, the method of kneading the mixture includes, but is not limited to, a method of kneading the mixture by a kneading device such as an extruder, twin rolls or a Banbury mixer.

The yield stress of the material for insulating substrate in the present invention is preferably 4.9 kPa or more when combustion residues of the material combusted by heating for 30 minutes under the radiant heating condition of 50 $kW/m^2$ are compressed at a rate of 0.1 cm/s in a burning test according to ASTM E 1354. When the yield stress is less than 4.9 kPa, combustion residues may easily collapse by slight force, to make flame retardancy insufficient. That is, a sintered body of the material for insulating substrate, or a sintered body of a laminate thereof, preferably maintains its shape throughout combustion in order to sufficiently exhibit the performance thereof as a flame retardant coating. The yield stress is more preferably 15.0 kPa or more.

The material for insulating substrate in the present invention is preferably molded into an insulating substrate or dissolved in a suitable solvent to form a varnish for impregnation or coating. Further, the material for insulating substrate is used preferably as a laminate, a printed board, a core layer or buildup layer in a multi-layer substrate, copper foil with resin, a copper-clad laminate, a polyimide film, a film for TAB, and a prepreg used therein, but the use of the material for insulating substrate in the present invention is not limited thereto.

The method of forming the material for insulating substrate in the present invention includes, but is not limited to, a method of melt-kneading the material in an extruder, and extruding and forming it into a film through a T die or circular die (extrusion molding method); a method of dissolving or dispersing the material in a solvent such as an organic solvent and then cast molding it into a film (cast molding method); and a method of dipping a substrate consisting of an inorganic material such as glass or a substrate in the form of a cloth or nonwoven fabric consisting of an organic polymer, in a varnish obtained by dissolving or dispersing the material in a solvent such as an organic solvent, followed by molding the substrate into a film (dip forming method). In particular, the extrusion molding method or the cast molding method is preferable to make a multi-layer substrate thin. The substrate used in the dip forming method includes, but is not limited to, a glass cloth, aramid fibers, and polyparaphenylene benzoxazole fibers.

The material for insulating substrate in the present invention comprises the thermoplastic resin and/or thermosetting resin and the layered silicate, and thus has excellent physical properties and transparency. Unlike usual inorganic fillers, the layered silicate can attain excellent physical properties without being incorporated in a large amount, and therefore, the insulating substrate using the same can be made thinner and thus used as a high-density and thin multi-layer print substrate. The material for insulating substrate in the present invention can also bring about an improvement in heat resistance and a reduction in heat coefficient of linear expansion ray expansivity based on a higher glass transition temperature and heat-resistant deformation temperature by binding of a molecular chain of resin to the layered silicate, as well as an improvement in dimensional stability based on the effect of the layered silicate as

a nucleating agent on formation of crystals. By addition of the layered silicate, the material for insulating substrate according to this invention has an action of preventing the deterioration of dimensional stability caused by swelling upon water absorption and moisture absorption.

The material for insulating substrate in this invention forms a sintered body of the layered silicate upon combustion to maintain the shape of its combustion residues. Accordingly, the combustion resides do not collapse after combustion, to prevent flame spread. Accordingly, the material for insulating substrate in this invention exhibits excellent flame retardancy. By further combination with a non-halogen flame retardant such as metal hydroxide or melamine derivatives, high physical properties and high flame retardancy can be simultaneously achieved without adversely affecting the environment.

BEST MODE FOR CARRYING OUT THE INVENTION

Hereinafter, the present invention is described in more detail by reference to the Examples, but the present invention is not limited to the Examples.

(Example 1)

92.3 parts by weight of modified polyphenylene ether-based resin (Xyron (PKL) X9102, manufactured by Asahi Kasei Corporation) as thermoplastic resin and 7.7 parts by weight of swelling fluorine mica (Somasif MAE-100, manufactured by Co-op Chemical Co., Ltd.) subjected as layered silicate to organization treatment with a distearyldimethyl quaternary ammonium salt were fed to a small extruder (TEX30, manufactured by The Japan Steel Works, Ltd.) and melt-kneaded at a temperature set at 280°C and extruded into strands, and the extruded strands were formed into pellets by a pelletizer, to give a material for insulating substrate.

Then, the resulting material for insulating substrate was rolled by pressing with upper and lower hot presses controlled at a temperature of 280°C respectively to prepare plate moldings of 2 mm and 100 μm in thickness.

(Example 2)

Pellets as a material for insulating substrate and plate moldings of 2 mm and 100 μm in thickness were prepared in the same manner as in Example 1 except that 20 parts by weight of magnesium hydroxide (KISUMA 5J, manufactured by Kyowa Chemical Industry Co., Ltd.) were further blended as a flame retardant.

(Example 3)

70 parts by weight of alicyclic hydrocarbon-based resin (norbornane-based resin, Zeonor 1600R, manufactured by Nippon Zeon Co., Ltd.) as thermoplastic resin and 20 parts by weight of swelling fluorine mica (Somasif MAE-100, manufactured by Co-op Chemical Co., Ltd.) subjected as layered silicate to organization treatment with a distearyldimethyl quaternary ammonium salt were introduced at a resin concentration of 30% by weight into cyclohexane (special grade, manufactured by Wako Pure Chemical Industries, Ltd.), and the mixture was stirred, mixed and dissolved. 85 parts by weight of synthetic silica (ELSIL (in a spherical form), manufactured by Mitsubishi Materials Corporation) and 30 parts by weight of triallyl trimellitate (TRIAM705, manufactured by Sankyo Co., Ltd.) were added to the above solution and mixed under stirring to give a solution which was then dried to remove the solvent, whereby a material for insulating substrate was obtained.

Then, the resulting material for insulating substrate was rolled by pressing with upper and lower hot presses controlled at a temperature of 280°C respectively to prepare plate moldings of 2 mm and 100 μm in thickness.

(Example 4)

92.3 parts by weight of polyether imide resin as thermoplastic resin, 7.7 parts by weight of swelling fluorine mica (Somasif MAE-100, manufactured by Co-op Chemical Co., Ltd.) subjected as layered silicate to organization treatment with a distearyldimethyl quaternary ammonium salt and 20 parts by weight of magnesium hydroxide (KISUMA 5J, manufactured by Kyowa Chemical Industry Co., Ltd.) as a flame retardant were fed to a small extruder (TEX30, manufactured by The Japan Steel Works, Ltd.) and melt-kneaded and extruded into strands, and the extruded strands were formed into pellets by a pelletizer, to give a material for insulating substrate.

Then, the resulting material for insulating substrate was rolled by pressing with upper and lower hot presses controlled at a temperature of 350°C respectively to prepare plate moldings of 2 mm and 100 μm in thickness.

(Example 5)

92.3 parts by weight of an epoxy resin composition consisting of 57.7 parts by weight of bisphenol F type epoxy resin (EPICLON 830LVP, manufactured by Dainippon Ink and Chemicals, Inc.), 15.7 parts by weight of BT resin (BT2100B, manufactured by Mitsubishi Gas Chemical Company Inc.), 15.7 parts by weight of neopentyl glycol diglycidyl ether, 2.1 parts by weight of γ-glycidoxypropyltrimethoxysilane (A-187, manufactured by Nippon Unicar Co., Ltd.), and 1.1 pars by weight of acetyl acetone iron (Nihon Kagaku Sangyo Co., Ltd.) as a curing catalyst, 7.7 parts by weight of swelling fluorine mica (Somasif MAE-100, manufactured by Co-op Chemical Co., Ltd.) subjected as layered silicate to organization treatment with a distearyldimethyl quaternary ammonium salt and 20 parts by weight of magnesium hydroxide (KISUMA 5J, manufactured by Kyowa Chemical Industry) as a flame retardant were kneaded for 1 hour in a stirring mill and then defoamed to give a liquid insulating resin composition.

Then, the resulting liquid insulating resin composition was cured by heating at 110°C for 3 hours and further heating at 160°C for 3 hours, to give a material for insulating substrate which was then formed into plate moldings of 2 mm and 100 μm in thickness.

(Examples 6 to 11)

90 parts by weight of solid epoxy resin (Epikote 1007, manufactured by Yuka Shell Epoxy Co., Ltd.), 10 parts by weight of naturally occurring montmorillonite (New S-Ben D, manufactured by Hojun Yoko Co., Ltd.) subjected as layered silicate to organization treatment with a distearyldimethyl quaternary ammonium salt, and 0.1, 5, 10, 70, 80 and 100 parts by weight of magnesium hydroxide (KISUMA 5J, manufactured by Kyowa Chemical Industry Co., Ltd.) as a flame retardant were fed to a small extruder (TEX30, manufactured by The Japan Steel Works, Ltd.) and melt-kneaded at 100°C and extruded into strands, and the extruded strands were formed into pellets by a pelletizer.

The pellets were dissolved in methyl ethyl ketone, and to this solution were added dicyandiamide (CG-1200, manufactured by BTI Japan Co., Ltd.) in an amount of 3 parts by weight relative to 90 parts by weight of the solid epoxy content and a curing catalyst (Curezol 2E4HZ, manufactured by Shikoku Corporation) in an amount of 3 parts by weight relative to 90 parts by weight of the solid epoxy content, and the mixture was sufficiently stirred and defoamed to prepare an insulating resin composition solution.

Then, the resulting insulating resin composition solution was placed in a mold or applied onto a polyethylene terephthalate sheet, to remove the solvent, and then cured by heating at 110°C for 3 hours and further at 160°C for 3 hours to give a material for insulating substrate which was then formed into plate moldings of 2 mm and 100 μm in thickness.

(Examples 12 to 17)

90 parts by weight of solid epoxy resin (Epikote 1007, manufactured by Yuka Shell Epoxy Co., Ltd.), 10 parts by weight of epoxy-modified butadiene rubber (Denalex R-45EPT, Nagase Chemtex Corporation) as a rubber component, 30 parts by weight of magnesium hydroxide (KISUMA 5J, manufactured by Kyowa Chemical Industry Co., Ltd.) as a flame retardant and 0.1, 1, 5, 20, 50 and 100 parts by weight of synthetic mica (ME-100, Co-op Chemical Co., Ltd.) as layered silicate were fed to a small extruder (TEX30, manufactured by The Japan Steel Works, Ltd.) and melt-kneaded at 100°C and extruded into strands, and the extruded strands were formed into pellets by a pelletizer.

The pellets were dissolved in methyl ethyl ketone, and to this solution were added dicyandiamide (CG-1200, manufactured by BTI Japan Co., Ltd.) in an amount of 3 parts by weight relative to 90 parts by weight of the solid epoxy content and a curing catalyst (Curezol 2E4HZ, manufactured by Shikoku Corporation) in an amount of 3 parts by weight relative to 90 parts by weight of the solid epoxy content, and the mixture was sufficiently stirred and defoamed to prepare an insulating resin composition solution.

Then, the resulting insulating resin composition solution was placed in a mold or applied onto a polyethylene terephthalate sheet, to remove the solvent, and then cured by heating at 110°C for 3 hours and further at 160°C for 3 hours to give a material for insulating substrate which was then formed into plate moldings of 2 mm and 100 μm in thickness.

(Example 18)

40 parts by weight of polyphenylene ether resin (Xyron X9102, manufactured by Asahi Kasei Corporation) as thermoplastic resin, 10 parts by weight of epoxy-modified butadiene rubber (Denalex R-45EPT, Nagase Chemtex Corporation) as a rubber component, 10 parts by weight of synthetic mica (Somasif MAE-100, manufactured by Co-op Chemical Co., Ltd.) subjected as layered silicate to organization treatment with a distearyldimethyl quaternary ammonium salt and 50 parts by weight of melamine derivative melamine cyanurate (Nissan Chemical Industries, Ltd.) as

a flame retardant were fed to a small extruder (TEX30, manufactured by The Japan Steel Works, Ltd.) and melt-kneaded at 280°C and extruded into strands, and the extruded strands were formed into pellets by a pelletizer.

The pellets were dissolved in toluene, and to this solution were added liquid bisphenol A type epoxy resin (D. E.R. 331L, manufactured by Dow Chemical Japan) in an amount of 60 parts by weight relative to 40 parts by weight of the polyphenylene ether resin, dicyandiamide (CG-1200, manufactured by BTI Japan Co., Ltd.) as a curing catalyst in an amount of 2 parts by weight relative to 60 parts by weight of the solid epoxy content and a curing catalyst (Curezol 2E4HZ, manufactured by Shikoku Corporation) in an amount of 2 parts by weight relative to 60 parts by weight of the solid epoxy content, and the mixture was sufficiently stirred and defoamed to prepare an insulating resin composition solution.

Then, the resulting insulating resin composition solution was placed in a mold or applied onto a polyethylene terephthalate sheet, to remove the solvent, and then cured by heating at 110°C for 3 hours and further at 160°C for 3 hours to give a material for insulating substrate which was then formed into plate moldings of 2 mm and 100 μm in thickness.

(Example 19)

30 parts by weight of 6-nylon resin (T-850, manufactured by Toyobo Co., Ltd.) as thermoplastic resin, 10 parts by weight of naturally occurring montmorillonite (Bengel A, manufactured by Hojun Yoko Co., Ltd.) as layered silicate, and 40 parts by weight of magnesium hydroxide (KISUMA 5J, manufactured by Kyowa Chemical Industry Co., Ltd.) as a flame retardant were fed to a small extruder (TEX30, manufactured by The Japan Steel Works, Ltd.) and melt-kneaded at 250°C and extruded into strands, and the extruded strands were formed into pellets by a pelletizer.

The pellets were dissolved in o-chlorophenol, and to this solution were added liquid bisphenol A type epoxy resin (D.E.R. 331L, manufactured by Dow Chemical Japan) in an amount of 70 parts by weight relative to 30 parts by weight of the 6-nylon resin, dicyandiamide (CG-1200, manufactured by BTI Japan) as a curing catalyst in an amount of 2.3 parts by weight relative to 70 parts by weight of the solid epoxy content and a curing catalyst (Curezol 2E4HZ, manufactured by Shikoku Chemicals Corporation) in an amount of 2.3 parts by weight relative to 90 parts by weight of the solid epoxy content, and the mixture was sufficiently stirred and defoamed to prepare an insulating resin composition solution.

Then, the resulting insulating resin composition solution was placed in a mold or applied onto a polyethylene terephthalate sheet, to remove the solvent, and then cured by heating at 110°C for 3 hours and further at 160°C for 3 hours to give a material for insulating substrate which was then formed into plate moldings of 2 mm and 100 μm in thickness.

(Example 20)

90 parts by weight of polyether ether ketone resin (450G2, manufactured by Victorex, plc.) as thermoplastic resin, 10 parts by weight of naturally occurring montmorillonite (New S-Ben D, manufactured by Hojun Yoko Co., Ltd.) subjected as layered silicate to organization treatment with a distearyldimethyl quaternary ammonium salt, and 10 parts by weight of a melamine derivative melamine cyanurate (Nissan Chemical Industries, Ltd.) as a flame retardant were fed to a small extruder (TEX30, manufactured by The Japan Steel Works, Ltd.) and melt-kneaded at 370°C and extruded into strands, and the extruded strands were formed into pellets by a pelletizer.

Then, the resulting material for insulating substrate was rolled by pressing with upper and lower hot presses controlled at a temperature of 370°C respectively to prepare plate moldings of 2 mm and 100 μm in thickness.

(Example 21)

10 parts by weight of synthetic mica (Somasif MAE-100, manufactured by Co-op Chemical Co., Ltd.) subjected as layered silicate to organization treatment with a distearyldimethyl quaternary ammonium salt were added to 90 parts by weight of thermosetting polyimide resin (SKYBOND 703, manufactured by I.S.T.), to give a varnish.

Then, the resulting varnish was applied onto a polyethylene terephthalate film, and the resulting sheet was heated at 120°C for 60 hours, whereby the sheet of 100 μm in thickness and a plate molding of 2 mm in thickness having the sheet laminated thereon were prepared.

(Comparative Example 1)

A material for insulating substrate and plate moldings of 2 mm and 100 μm in thickness were prepared in the same manner as in Example 1 except that 7.7 parts by weight of calcium carbonate having an average particle diameter of 50 μm were used in place of 7.7 parts by weight of swelling fluorine mica (Somasif MAE-100, manufactured by Co-op Chemical Co., Ltd.).

(Comparative Example 2)

A material for insulating substrate and plate moldings of 2 mm and 100 µm in thickness were prepared in the same manner as in Example 2 except that the swelling fluorine mica (Somasif MAE-100, manufactured by Co-op Chemical Co., Ltd.) was not compounded.

(Comparative Example 3)

A material for insulating substrate and plate moldings of 2 mm and 100 µm in thickness were prepared in the same manner as in Example 3 except that the swelling fluorine mica (Somasif MAE-100, manufactured by Co-op Chemical Co., Ltd.) was not compounded.

(Comparative Example 4)

A material for insulating substrate and plate moldings of 2 mm and 100 µm in thickness were prepared in the same manner as in Example 4 except that the swelling fluorine mica (Somasif MAE-100, manufactured by Co-op Chemical Co., Ltd.) was not compounded.

(Comparative Example 5)

A material for insulating substrate and plate moldings of 2 mm and 100 µm in thickness were prepared in the same manner as in Example 5 except that the swelling fluorine mica (Somasif MAE-100, manufactured by Co-op Chemical Co., Ltd.) was not compounded.

(Comparative Example 6)

A material for insulating substrate and plate moldings of 2 mm and 100 µm in thickness were prepared in the same manner as in Examples 6 to 11 except that the amount of magnesium hydroxide added was 0.05 part by weight, and the amount of naturally occurring montmorillonite added was 0.05 part by weight.

(Comparative Example 7)

A material for insulating substrate and plate moldings of 2 mm and 100 µm in thickness were prepared in the same manner as in Examples 6 to 11 except that the amount of magnesium hydroxide added was 120 parts by weight.

(Comparative Example 8)

A material for insulating substrate and plate moldings of 2 mm and 100 µm in thickness were prepared in the same manner as in Examples 12 to 17 except that the amount of synthetic mica added was 0.05 part by weight.

(Comparative Example 9)

A material for insulating substrate and plate moldings of 2 mm and 100 µm in thickness were prepared in the same manner as in Examples 12 to 17 except that the amount of synthetic mica added was 130 parts by weight.

(Comparative Example 10)

A material for insulating substrate and plate moldings of 2 mm and 100 µm in thickness were prepared in the same manner as in Example 18 except that the amount of the melamine derivative added was 0.05 part by weight, and the amount of synthetic mica added was 0.05 part by weight.

(Comparative Example 11)

A material for insulating substrate and plate moldings of 2 mm and 100 µm in thickness was prepared in the same manner as in Example 18 except that the amount of the melamine derivative added was 120 parts by weight.

<Evaluation>

The performances (average interlaminar distance of the layered silicate, the percentage of the layered silicate dispersed in 5 layers or less, via processability, shape retention upon combustion, strength of a coating of combustion residues) of the plate moldings obtained in Examples 1 to 21 and Comparative Examples 1 to 11 were evaluated in the following methods. The results are shown in Tables 1 to 6.

(1) Average interlaminar distance of the layered silicate

The average interlaminar distance (nm) was determined by measuring 2θ of a diffraction peak obtained by diffraction on the lamination plane of the layered silicate in the plate molding of 2 mm in thickness, with an X-ray diffraction measuring device (RINT1100, manufactured by Rigaku Corporation), and then calculating the distance (d) between (001) faces of the layered silicate, according to the Bragg's diffraction formula (4) :

$$\lambda = 2d\sin\theta \qquad (4)$$

wherein λ is 1.54, d represents the distance between the (001) faces of layered silicate, and θ represents a diffraction angle.

(2) Percentage of the layered silicates dispersed in 5 or less layers

The percentage of the layered silicate dispersed in 5 or less layers was determined by observing the layered silicate at 50,000× to 100,000× magnification under a transmission electron microscope, determining the number of aggregated layers (Y) dispersed in 5 or less layers/the number of total aggregated layers (X) of the layered silicate observable in a predetermined area, and calculating the percentage from the following equation (3):
Percentage (%) of the layered silicate dispersed in 5 or

$$\text{less layers} = (Y/X)\ '\ 100 \qquad (3)$$

(3) Via processability

Using a high-peak short-pulse oscillation carbon dioxide gas laser processing machine (ML605 GTX-5100U, manufactured by Mitsubishi Electric Corporation), a micro-via was formed in the plate molding of 100 μm in thickness. Then, the surface of the vias was observed under a scanning electron microscope (SEM), and the via processability was evaluated under the following evaluation criteria:

○: Small difference in via shape and in via opening with less generation of carbides.
×: Large difference in via shape and in via opening with much generation of carbides.

(4) Shape retention upon combustion

According to ASTM E 1354 "Test Method for Combustibility of Building Materials", the plate molding of 2 mm in thickness, cut in a size of 100 mm×100 mm, was combusted by irradiation with 50 $kW/m^2$ heat ray by a corn calorie meter. The change in the shape of the plate molding before and after combustion was observed with visual observation, and the shape retention upon combustion was evaluated under the following evaluation criteria:

○: Slight change in shape
×: Significant change in shape

(5) Maximum exotherm rate and strength of a coating of combustion residues

According to ASTM E 1354 "Test Method for Combustibility of Building Materials", the plate molding of 2 mm in thickness, cut in a size of 100 mmx100 mm, was combusted by irradiation with 50 $kW/m^2$ heat ray by a corn calorie meter. In this combustion, the maximum exotherm rate ($kW/m^2$) was measured. Further, the combustion residues were compressed at a rate of 0.1 cm/s, and the strength of a coating of the combustion residues (kPa) was measured by a strength measuring meter.

Table 1

| | | Example 1 | | Example 2 | | Example 3 | | Example 4 | | Example 5 | |
|---|---|---|---|---|---|---|---|---|---|---|---|
| Resin composition (parts by weight) | Resin | Modified PPE resin | 92. 3 | Modified PPE resin | 92. 3 | Alicyclic hydrocarbon resin | 70 | Polyether imide resin | 92. 3 | Bisphenol F type epoxy resin | 55 |
| | | | | | | | | | | BT resin | 15 |
| | | | | | | | | | | Neopentyl glycol diglycidyl ether | 15 |
| | Layered silicate | Swelling fluorine mica | 7. 7 | Swelling fluorine mica | 7. 7 | Swelling fluorine mica | 20 | Swelling fluorine mica | 7. 7 | Swelling fluorine mica | 7. 7 |
| | Flame retardant | – | | Magnesium hydroxide | 20 | – | | Magnesium hydroxide | 20 | Magnesium hydroxide | 20 |
| | Others | – | | – | | Synthetic silica | 85 | – | | γ-glycidoxypropyl trimethoxysilane | 2 |
| | | | | | | TRIAM | 30 | | | Acetyl acetone iron | 1 |
| Evaluation | Average interlaminar distance (nm) | 3. 5< | | 3. 5< | | 3. 5< | | 3. 5< | | 3. 5< | |
| | Percentage of layered silicate dispersed in 5 or less layers | 10< | | 10< | | 10< | | 10< | | 10< | |
| | Via processability | ○ | | ○ | | ○ | | ○ | | ○ | |
| | Shape retention upon combustion | ○ | | ○ | | ○ | | ○ | | ○ | |
| | Maximum exotherm rate ($kW/m^2$) | 500 | | 350 | | 300 | | 300 | | 300 | |
| | Strength of a coating of combustion residues (kPa) | 5 | | 20 | | 6 | | 8 | | 8 | |

Table 2

| | | Example 6 | | Example 7 | | Example 8 | | Example 9 | | Example 10 | | Example 11 | |
|---|---|---|---|---|---|---|---|---|---|---|---|---|---|
| Resin composition (parts by weight) | Resin | Solid epoxy resin | 90 | Solid epoxy resin | 90 | Solid epoxy resin | 90 | Solid epoxy resin | 90 | Solid epoxy resin | 90 | Solid epoxy resin | 90 |
| | Layered silicate | Montmorillo-nite | 10 | Montmorillo-nite | 10 | Montmorillo-nite | 10 | Montmorillo-nite | 10 | Montmorillo-nite | 10 | Montmorillo-nite | 10 |
| | Flame retardant | Magnesium hydroxide | 0. 1 | Magnesium hydroxide | 5 | Magnesium hydroxide | 10 | Magnesium hydroxide | 70 | Magnesium hydroxide | 80 | Magnesium hydroxide | 100 |
| | Others | Curing agent | 3 | Curing agent | 3 | Curing agent | 3 | Curing agent | 3 | Curing agent | 3 | Curing agent | 3 |
| | | Catalyst | 3 | Catalyst | 3 | Catalyst | 3 | Catalyst | 3 | Catalyst | 3 | Catalyst | 3 |
| Evaluation | Average interlaminar distance (nm) | 3. 5< | | 3. 5< | | 3. 5< | | 3. 5< | | 3. 5< | | 3. 5< | |
| | Percentage of layered silicate dispersed in 5 or less layers | 10< | | 10< | | 10< | | 10< | | 10< | | 10< | |
| | Via processability | ○ | | ○ | | ○ | | ○ | | ○ | | ○ | |
| | Shape retention upon combustion | ○ | | ○ | | ○ | | ○ | | ○ | | ○ | |
| | Maximum exotherm rate ($kW/m^2$) | 500 | | 450 | | 410 | | 390 | | 380 | | 360 | |
| | Strength of a coating of combustion residues (kPa) | 7 | | 8 | | 8 | | 9 | | 9 | | 9 | |

Table 3

| | | Example 12 | | Example 13 | | Example 14 | | Example 15 | | Example 16 | | Example 17 | |
|---|---|---|---|---|---|---|---|---|---|---|---|---|---|
| Resin composition (parts by weight) | Resin | Solid epoxy resin | 90 | Solid epoxy resin | 90 | Solid.epoxy resin | 90 | Solid epoxy resin | 90 | Solid epoxy resin | 90 | Solid epoxy resin | 90 |
| | | Epoxy-modified butadiene rubber | 10 | Epoxy-modified butadiene rubber | 10 | Epoxy-modified butadiene rubber | 10 | Epoxy-modified butadiene rubber | 10 | Epoxy-modified butadiene rubber | 10 | Epoxy-modified butadiene rubber | 10 |
| | Layered silicate | Synthetic mica | 0. 1 | Synthetic mica | 1 | Synthetic mica | 5 | Synthetic mica | 20 | Synthetic mica | 50 | Synthetic mica | 100 |
| | Flame retardant | Magnesium hydroxide | 30 | Magnesium hydroxide | 30 | Magnesium hydroxide | 30 | Magnesium hydroxide | 30 | Magnesium hydroxide | 30 | Magnesium hydroxide | 30 |
| | Others | Curing agent | 3 | Curing agent | 3 | Curing agent | 3 | Curing agent | 3 | Curing agent | 3 | Curing agent | 3 |
| | | Catalyst | 3 | Catalyst | 3 | Catalyst | 3 | Catalyst | 3 | Catalyst | 3 | Catalyst | 3 |
| Evaluation | Average interlaminar distance (nm) | 3. 5< | | 3. 5< | | 3. 5< | | 3. 5< | | 3. 5< | | 3. 5< | |
| | Percentage of layered silicate dispersed in 5 or less layers | 10< | | 10< | | 10< | | 10< | | 10< | | 10< | |
| | Via processability | ○ | | ○ | | ○ | | ○ | | ○ | | ○ | |
| | Shape retention upon combustion | ○ | | ○ | | ○ | | ○ | | ○ | | ○ | |
| | Maximum exotherm rate ($kW/m^2$) | 500 | | 480 | | 450 | | 400 | | 380 | | 370 | |
| | Strength of a coating of combustion residues (kPa) | 6 | | 7 | | 5 | | 7 | | 14 | | 23 | |

Table 4

| | | Example 18 | | Example 19 | | Example 20 | | Example 21 | |
|---|---|---|---|---|---|---|---|---|---|
| Resin composition (parts by weight) | Resin | Liquid bisphenol A type epoxy resin | 60 | Liquid bisphenol A type epoxy resin | 70 | PEEK resin | 90 | Thermosetting polyimide resin | 90 |
| | | PPE resin | 40 | 6-nylon resin | 30 | | | | |
| | | Epoxy-modified butadiene rubber | 10 | | | | | | |
| | Layered silicate | Synthetic mica | 10 | Montmorillonite | 10 | Montmorillonite | 10 | Synthetic mica | 10 |
| | Flame retardant | Melamine derivative | 50 | Magnesium hydroxide | 40 | Melamine derivative | 10 | – | |
| | Others | Curing agent | 2 | Curing agent | 2. 3 | – | | – | |
| | | Catalyst | 2 | Catalyst | 2. 3 | | | | |
| Evaluation | Average interlaminar distance (nm) | 3. 5< | | 3. 5< | | 3. 5< | | 3. 5< | |
| | Percentage of layered silicate dispersed in 5 or less layers | 10< | | 10< | | 10< | | 10< | |
| | Via processability | ○ | | ○ | | ○ | | ○ | |
| | Shape retention upon combustion | ○ | | ○ | | ○ | | ○ | |
| | Maximum exotherm rate ($kW/m^2$) | 410 | | 400 | | 320 | | 300 | |
| | Strength of a coating of combustion residues (kPa) | 9 | | 8 | | 10 | | 10 | |

Table 5

| | | Comparative Example 1 | | Comparative Example 2 | | Comparative Example 3 | | Comparative Example 4 | | Comparative Example 5 | |
|---|---|---|---|---|---|---|---|---|---|---|---|
| Resin composition (parts by weight) | Resin | Modified PPE resin | 92. 3 | Modified PPE resin | 92. 3 | Alicyclic hydrocarbon resin | 70 | Polyether imide resin | 92. 3 | Bisphenol F type epoxy resin | 55 |
| | | | | | | | | | | BT resin | 15 |
| | | | | | | | | | | Neopentyl glycol diglycidyl ether | 15 |
| | Layered silicate | — | | — | | — | | — | | — | |
| | Flame retardant | — | | Magnesium hydroxide | 20 | Magnesium hydroxide | 20 | Magnesium hydroxide | 20 | Magnesium hydroxide | 20 |
| | Others | Calcium carbonate | 7. 7 | — | | Synthetic silica | 85 | — | | γ-glycidoxypropyltrimethoxysilane | 2 |
| | | | | | | TRIAM | 30 | | | Acetyl acetone iron | 1 |
| Evaluation | Average interlaminar distance (nm) | — | | — | | — | | — | | — | |
| | Percentage of layered silicate dispersed in 5 or less layers | — | | — | | — | | — | | — | |
| | Via processability | × | | × | | × | | ○ | | ○ | |
| | Shape retention upon combustion | × | | × | | × | | × | | × | |
| | Maximum exotherm rate ($kW/m^2$) | 650 | | 500 | | 400 | | 400 | | 400 | |
| | Strength of a coating of combustion residues (kPa) | 1 | | No coating was formed | | Less than 1 | | 1 | | 1 | |

Table 6

| | | Comparative Example 6 | | Comparative Example 7 | | Comparative Example 8 | | Comparative Example 9 | | Comparative Example 10 | | Comparative Example 11 | |
|---|---|---|---|---|---|---|---|---|---|---|---|---|---|
| Resin composition (parts by weight) | Resin | Solid epoxy resin | 90 | Solid epoxy resin | 90 | Solid epoxy resin | 90 | Solid epoxy resin | 90 | Liquid bisphenol A type epoxy resin | 60 | Liquid bisphenol A type epoxy resin | 60 |
| | | | | | | | | | | PPE resin | 40 | PPE resin | 40 |
| | | | | | | Epoxy-modified butadiene rubber | 10 | Epoxy-modified butadiene rubber | 10 | Epoxy-modified butadiene rubber | 10 | Epoxy-modified butadiene rubber | 10 |
| | Layered silicate | Montmorillo-nite | 0. 05 | Montmorillo-nite | 10 | Synthetic mica | 0. 05 | Synthetic mica | 130 | Synthetic mica | 0. 05 | Synthetic mica | 10 |
| | Flame retardant | Magnesium hydroxide | 0. 05 | Magnesium hydroxide | 120 | Magnesium hydroxide | 30 | Magnesium hydroxide | 30 | Melamine derivative | 0. 05 | Melamine derivative | 120 |
| | Others | Curing agent | 2 | Curing agent | 2 | Curing agent | 2 | Curing agent | 2 | Curing agent | 2 | Curing agent | 2 |
| | | Catalyst | 1 | Catalyst | 1 | Catalyst | 1 | Catalyst | 1 | Catalyst | 2 | Catalyst | 2 |
| Evaluation | Average interlaminar distance (nm) | 3. 5< | | 3. 5< | | 3. 5< | | 3. 5< | | 3. 5< | | – | |
| | Percentage of layered silicate dispersed in 5 or less layers | 10< | | 10< | | 10< | | 4 | | 10< | | 10< | |
| | Via processability | ○ | | × | | × | | × | | ○ | | × | |
| | Shape retention upon combustion | × | | ○ | | × | | ○ | | × | | × | |
| | Maximum exotherm rate ($kW/m^2$) | 850 | | 350 | | 620 | | 350 | | 810 | | 340 | |
| | Strength of a coating of combustion residues (kPa) | Less than 1 | | 8 | | 1 | | 23 | | Less than 1 | | 1 | |

The tables show that in the plate moldings prepared using the materials for insulating substrate obtained in Examples 1 to 21, the average interlaminar distance of the layered silicate was 3 nm or more and simultaneously the percentage of the layered silicate dispersed in 5 or less layers was 10% or more, and thus the plate moldings were excellent in shape retention upon combustion and in via processability. Further, they easily formed a sintered body capable of serving as a flame retardant coating, and thus the maximum exotherm rate was low, and the strength of a coating of combustion residues was 4.9 kPa or more.

In the plate moldings consisting of the material for insulating substrate obtained in Comparative Example 1 by using calcium carbonate in place of swelling fluorine mica (layered silicate), on the other hand, calcium carbonate was not dispersed in a layered state, and thus the plate moldings were poor in shape retention upon combustion and in via processability, and they hardly formed a sintered body capable of serving as a flame retardant coating, and thus the maximum exotherm rate was very high, and the strength of a coating of combustion residues was extremely low.

The majority of the plate moldings consisting of the materials for insulating substrate obtained in Comparative Examples 2 to 5, wherein the layered silicate was not added, were poor in shape retention upon combustion and in via processability, and some combustion residues did not form a coating, or the strength of a coating of some combustion residues was extremely low.

The plate moldings consisting of the material for insulating substrate obtained in Comparative Example 8, wherein the amount of the layered silicate added was low, were poor in shape retention upon combustion and in via processability and the strength of a coating of combustion resides was low, while in the plate moldings consisting of the material for insulating substrate obtained in Comparative Example 9 wherein the amount of the layered silicate added was high, the percentage of the layered silicate dispersed in 5 or less layers was 4%, and the plate molding was poor in via processability.

The plate moldings consisting of the materials for insulating substrate obtained in Comparative Examples 6 and 10, wherein the amounts of the layered silicate and flame retardant added were low, were poor in shape retention upon combustion, and the maximum exotherm rate was high, and the strength of a coating of combustion residues was extremely low. The plate moldings consisting of the materials for insulating substrate obtained in Comparative Examples 7 and 11, wherein the amount of the flame retardant added was high, had problems such as insufficient via processability.

INDUSTRIAL APPLICABILITY

According to the present invention, there can be provided a material for insulating substrate, a laminate, copper foil with resin, a copper-clad laminate, a film for TAB and a prepreg, which are excellent in physical properties, dimensional stability, heat resistance, flame retardancy etc. and exhibit an excellent flame retardant effect particularly by a shape retention effect at the time of combustion.

## Claims

**1.** A material for insulating substrate,
which comprises 100 parts by weight of a thermoplastic resin or a mixture of a thermoplastic resin and a thermosetting resin and 0.1 to 100 parts by weight of a layered silicate.

**2.** The material for insulating substrate according to claim 1,
wherein the thermoplastic resin is at least one member selected from the group consisting of polyphenylene ether-based resin, polyphenylene ether-based resin modified with functional groups, a mixture of polyphenylene ether-based resin or polyphenylene ether-based resin modified with functional groups and polystyrene-based resin, alicyclic hydrocarbon-based resin, thermoplastic polyimide-based resin, polyether ether ketone resin, polyether sulfone resin, polyamide imide resin and polyester imide resin.

**3.** A material for insulating substrate,
which comprises 100 parts by weight of at least one thermosetting resin selected from the group consisting of phenol resin, urea resin, unsaturated polyester resin, allyl resin, thermosetting polyimide resin, bismaleimide triazine resin, thermosetting modified polyphenylene ether-based resin, silicon resin and benzooxazine-based resin and 0.1 to 100 parts by weight of a layered silicate.

**4.** The material for insulating substrate according to claim 1, 2 or 3,
which comprises 0.1 to 100 parts by weight of a flame retardant substantially free of a halogen-based composition.

**5.** A material for insulating substrate,
which comprises 0.1 to 100 parts by weight of a layered silicate and 0.1 to 100 parts by weight of a flame retardant substantially free of a halogen-based composition every 100 parts by weight of epoxy resin.

**6.** A material for insulating substrate,
which comprises a resin composition (A) containing 100 parts by weight of at least one kind of resin consisting of thermoplastic resin and/or thermosetting resin and 1 to 500 parts by weight of a layered silicate mixed with a resin composition (B) having a composition identical with or different from the resin composition (A) and containing at least one kind of thermoplastic resin and/or thermosetting resin.

**7.** The material for insulating substrate according to claim 6,
wherein the resin composition (A) comprises at least one resin selected from the group consisting of polyamide-based resin, polyphenylene ether-based resin and polyester resin, and
the resin composition (B) comprises epoxy-based resin.

**8.** The material for insulating substrate according to claim 4 or 5,
wherein the flame retardant is a metal hydroxide.

**9.** The material for insulating substrate according to claim 4 or 5,
wherein the flame retardant is a melamine derivative.

**10.** The material for insulating substrate according to claim 1, 2, 3, 4, 5, 6, 7, 8 or 9,
wherein the layered silicate is at least one member selected from the group consisting of montmorillonite, swelling mica and hectorite.

**11.** The material for insulating substrate according to claim 1, 2, 3, 4, 5, 6, 7, 8, 9 or 10,
wherein the layered silicate comprises an alkyl ammonium ion having 6 or more carbon atoms.

**12.** The material for insulating substrate according to claim 1, 2, 3, 4, 5, 6, 7, 8, 9, 10 or 11,
wherein the average interlaminar distance between (001) faces of the layered silicate, as determined by wide-angle X-ray diffractometry, is 3 nm or more, and
a part or the whole of the layered silicate is dispersed in 5 or less layers.

**13.** The material for insulating substrate according to claim 1, 2, 3, 4, 5, 6, 7, 8, 9, 10, 11 or 12,
which has the yield stress of combustion residues combusted by heating for 30 minutes under the radiant heating condition of 50 $kW/m^2$ in a burning test according to ASTM E 1354 of 4.9 kPa or more upon compression at a rate of 0.1 cm/s.

**14.** A laminate
which is obtainable by using the material for insulating substrate according to claim 1, 2, 3, 4, 5, 6, 7, 8, 9, 10, 11, 12 or 13.

**15.** A printed board
which is obtainable by using the material for insulating substrate according to claim 1, 2, 3, 4, 5, 6, 7, 8, 9, 10, 11, 12 or 13.

**16.** A copper foil with resin
which is obtainable by using the material for insulating substrate according to claim 1, 2, 3, 4, 5, 6, 7, 8, 9, 10, 11, 12 or 13.

**17.** A copper-clad laminate
which is obtainable by using the material for insulating substrate according to claim 1, 2, 3, 4, 5, 6, 7, 8, 9, 10, 11, 12 or 13.

**18.** A polyimide film
which is obtainable by using the material for insulating substrate according to claim 1, 2, 3, 4, 5, 6, 7, 8, 9, 10, 11, 12 or 13.

**19.** A film for TAB which is obtainable by using the material for insulating substrate according to claim 1, 2, 3, 4, 5, 6, 7, 8, 9, 10, 11, 12 or 13.

**20.** A prepreg which is obtainable by using the material for insulating substrate according to claim 1, 2, 3, 4, 5, 6, 7, 8, 9, 10, 11, 12 or 13.

## INTERNATIONAL SEARCH REPORT

International application No. PCT/JP01/10771

**A. CLASSIFICATION OF SUBJECT MATTER**

Int.Cl[7] C08L101/00, C08K3/34, C08J5/00, B32B27/20, H01L23/14, H01B3/00, H05K1/03, H05K3/46

According to International Patent Classification (IPC) or to both national classification and IPC

**B. FIELDS SEARCHED**

Minimum documentation searched (classification system followed by classification symbols)

Int.Cl[7] C08L1/00-101/16, C08K3/00-13/08, C08J5/00, H01L23/14, H01B3/00, H05K1/03, H05K3/46

Documentation searched other than minimum documentation to the extent that such documents are included in the fields searched

Electronic data base consulted during the international search (name of data base and, where practicable, search terms used)

WPI/L

**C. DOCUMENTS CONSIDERED TO BE RELEVANT**

| Category* | Citation of document, with indication, where appropriate, of the relevant passages | Relevant to claim No. |
|---|---|---|
| X | JP, 3-258835, A (Toyobo Co., Ltd.), 19 November, 1991 (19.11.91), Claims; Examples (family: none) | 1-20 |
| X | JP, 50-160182, A (Motoyuki IMAI), 25 December, 1975 (25.12.75), Claims; Examples (family: none) | 1-20 |
| X | JP, 59-223218, A (Toray Industries, Inc.), 15 December, 1984 (15.12.84), Claims; Examples (family: none) | 1-20 |
| X | EP, 873047, A2 (Hitachi Chem Co., Ltd.), 21 October, 1998 (21.10.98), Claims; page 4, lines 38 to 39; Examples & JP 10-287830 A Claims; Par. No. [0017]; Examples & US 6197149 B1 | 1-20 |

[X] Further documents are listed in the continuation of Box C.  [ ] See patent family annex.

* Special categories of cited documents:

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 12 March, 2002 (12.03.02) | 26 March, 2002 (26.03.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

## INTERNATIONAL SEARCH REPORT

International application No.
PCT/JP01/10771

C (Continuation). DOCUMENTS CONSIDERED TO BE RELEVANT

| Category* | Citation of document, with indication, where appropriate, of the relevant passages | Relevant to claim No. |
|---|---|---|
| X | JP, 8-23146, A (Hitachi Chemical Co., Ltd.), 23 January, 1996 (23.01.96), Claims; Par. No. [0014]; Examples (Family: none) | 1-20 |

Form PCT/ISA/210 (continuation of second sheet) (July 1998)